# EUROPEAN PATENT APPLICATION

(11) **EP 4 510 803 A1**
(43) Date of publication of application: **19.02.2025**
(21) Application number: 24181347.6
(22) Date of filing: 11.06.2024
(51) Int. Cl.: H10B 63/00, H10N 70/20, H10N 70/00

(54) **VARIABLE RESISTANCE MEMORY DEVICE AND ELECTRONIC APPARATUS INCLUDING THE SAME**

(30) Priority: 14.08.2023 KR 20230106464
(71) Applicant: Samsung Electronics Co., Ltd., Suwon-si, Gyeonggi-do 16677 (KR)
(72) Inventor: KIM, Yumin, 16678 Suwon-si (KR); KIM, Seyun, 16678 Suwon-si (KR); PARK, Garam, 16678 Suwon-si (KR); SONG, Hyunjae, 16678 Suwon-si (KR); YANG, Seungyeul, 16678 Suwon-si (KR); HYUN, Seungdam, 16678 Suwon-si (KR)
(74) Representative: Elkington and Fife LLP

(57) **Abstract**

A variable resistance memory device includes a channel layer (125), a resistance change layer (129) provided on the channel layer (125), the resistance change layer (129) having resistance characteristics that change based on an applied voltage and having a first oxygen diffusion activation energy, and an interface layer (127) provided between the channel layer (125) and the resistance change layer (129), the interface layer (127) having a second oxygen diffusion activation energy that is greater than the first oxygen diffusion activation energy of the resistance change layer (129).

## Description

### FIELD OF THE INVENTION

The disclosure relates to a variable resistance memory device and an electronic apparatus including the same.

### BACKGROUND OF THE INVENTION

Nonvolatile memory devices include a plurality of memory cells which retain data even when power is disconnected, and thus, are able to use the stored data again when power is supplied. Nonvolatile memory devices may be used in cellular phones, digital cameras, a portable digital assistants (PDAs), mobile computer devices, etc.

Recently, vertical NAND (VNAND) flash memory devices have been developed as high integration and low power are required, and as integration increases, to overcome the limitations of VNAND flash memory devices using charge trap layers, VNAND flash memory devices using resistance change materials have been researched.

### SUMMARY OF THE INVENTION

Provided are a variable resistance memory device and an electronic apparatus including the same.

Additional aspects will be set forth in part in the description which follows and, in part, will be apparent from the description, or may be learned by practice of the presented embodiments of the disclosure.

According to an aspect of the disclosure, a variable resistance memory device may include a channel layer, a resistance change layer provided on the channel layer, the resistance change layer having resistance characteristics that change based on an applied voltage and having a first oxygen diffusion activation energy, and an interface layer provided between the channel layer and the resistance change layer, the interface layer having a second oxygen diffusion activation energy that is greater than the first oxygen diffusion activation energy of the resistance change layer.

The resistance change layer may include Al₂O₃, In₂O₃, MgO, MoOs, Ta₂O₅, TiO₂, V₂O₅, or ZnO and the interface layer may include Al₂O₃, In₂O₃, MgO, MoOs, Ta₂O₅, TiO₂, V₂O₅, or ZnO.

The second oxygen diffusion activation energy of the interface layer may be about 0.2 eV to about 0.8 eV greater than the first oxygen diffusion activation energy of the resistance change layer.

The resistance change layer may include TiO₂, and the interface layer may include Ta₂O₅, Al₂O₃, or V₂O₅.

The resistance change layer may include Ta₂O₅, and the interface layer may include MoOs or ZnO.

The resistance change layer may include Al₂O₃, and the interface layer may include MgO or MoOs.

The resistance change layer may include V₂O₅, and the interface layer may include MgO or MoOs.

The resistance change layer may include ZnO, and the interface layer may include In₂O₃ or MgO.

The resistance change layer may include MoOs, and the interface layer may include In₂O₃ or MgO.

A thickness of the interface layer may be about 0.5 nm to about 3 nm.

According to an aspect of the disclosure, a variable resistance memory device may include a plurality of cell strings each extending vertically on a substrate, where each of the plurality of cell strings may include a channel layer, a resistance change layer provided inside the channel layer, the resistance change layer having resistance characteristics that change based on an applied voltage and having a first oxygen diffusion activation energy, an interface layer provided between the channel layer and the resistance change layer, the interface layer having a second oxygen diffusion activation energy that is greater than the first oxygen diffusion activation energy of the resistance change layer, and a plurality of gate electrodes provided outside the channel layer.

The first oxygen diffusion activation energy of the interface layer may be about 0.2 eV to about 0.8 eV greater than the second oxygen diffusion activation energy of the resistance change layer.

The variable resistance memory device may include Al₂O₃, In₂O₃, MgO, MoOs, Ta₂O₅, TiO₂, V₂O₅, or ZnO.

The interface layer may include Al₂O₃, In₂O₃, MgO, MoOs, Ta₂O₅, TiO₂, V₂O₅, or ZnO.

A thickness of the interface layer may be about 0.5 nm to about 3 nm.

The channel layer may include a channel hole extending in a direction perpendicular to the substrate.

The channel layer, the interface layer, and the resistance change layer may have a cylindrical shape and may at least partially surround the channel hole.

The plurality of gate electrodes may be spaced apart in the direction perpendicular to the substrate and the plurality of gate electrodes may at least partially surround the channel layer.

The variable resistance memory device may include a gate insulating layer at least partially surrounding the channel layer, where the gate insulating layer may be between the plurality of gate electrodes and the channel layer.

According to an aspect of the disclosure, an electronic apparatus may include a variable resistance memory device including a plurality of cell strings each extending vertically on a substrate, where each of the plurality of cell strings may include a channel layer, a resistance change layer provided inside the channel layer, the resistance change layer having resistance characteristics that change based on an applied voltage and having a first oxygen diffusion activation energy, an interface layer provided between the channel layer and the resistance change layer, the interface layer having a second oxygen diffusion activation energy that is greater than the first oxygen diffusion activation energy of the resistance change layer and a plurality of gate electrodes provided outside the channel layer.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1 is a perspective view illustrating a variable resistance memory device according to an embodiment;
FIG. 2 is a cross-sectional view illustrating a cell string according to an embodiment;
FIG. 3 is an enlarged view of portion A of a memory cell shown in FIG. 2 according to an embodiment;
FIG. 4 is an enlarged view of portion B of FIG. 2 according to an embodiment;
FIG. 5 is a circuit diagram illustrating a variable resistance memory device according to an embodiment;
FIG. 6A is a diagram illustrating a variable resistance memory device according to a comparative example;
FIG. 6B is a diagram illustrating a state in which a set voltage is applied to the variable resistance memory device shown in FIG. 6A;
FIG. 6C is a diagram illustrating a state in which a reset voltage is applied to the variable resistance memory device shown in FIG. 6B;
FIG. 7A is a diagram illustrating a variable resistance memory device according to an embodiment;
FIG. 7B is a diagram illustrating a state in which a set voltage is applied to the variable resistance memory device shown in FIG. 7A according to an embodiment;
FIG. 7C is a diagram illustrating a state in which a reset voltage is applied to the variable resistance memory device shown in FIG. 7B according to an embodiment;
FIG. 8 is a diagram illustrating a model of a variable resistance memory device manufactured to measure I-V characteristics through simulation experiments according to an embodiment;
FIG. 9A is a graph illustrating I-V characteristics when an interface layer has the same oxygen diffusion activation energy as a resistance change layer in the variable resistance memory device shown in FIG. 8 according to an embodiment;
FIG. 9B is a graph illustrating I-V characteristics when an interface layer has a greater oxygen diffusion activation energy than the resistance change layer in the variable resistance memory device shown in FIG. 8 according to an embodiment;
FIG. 10 is a graph illustrating an on/off current ratio according to an oxygen diffusion activation energy difference between an interface layer and the resistance change layer in the variable resistance memory device shown in FIG. 8, according to an embodiment;
FIG. 11 is a diagram illustrating a variable resistance memory device according to an embodiment;
FIG. 12 is a block diagram illustrating a memory system according to an embodiment; and
FIG. 13 is a block diagram illustrating a neuromorphic apparatus and an external device connected thereto, according to an embodiment.

### DETAILED DESCRIPTION

Reference will now be made in detail to embodiments, examples of which are illustrated in the accompanying drawings, where like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described in detail with reference to the accompanying drawings. Like reference numerals in the drawings denote like elements, and the size of each element in the drawings may be exaggerated for clarity and convenience of description. Embodiments described below are merely examples, and various modifications may be made from these embodiments.

Hereinafter, what is described as "above" or "on" may include those directly on, underneath, left, and right in contact, as well as above, below, left, and right in non-contact. The singular forms are intended to include the plural forms as well, unless the context clearly indicates otherwise. Also, when a part "includes" any element, it means that the part may further include other elements, rather than excluding other elements, unless otherwise stated.

The term "the" and the similar indicative terms may be used in both the singular and the plural. If there is no explicit description of the order of steps constituting a method or no contrary description thereto, these steps may be performed in an appropriate order, and are not limited to the order described.

In addition, the terms ".. unit", "module", etc. described herein may refer to a unit that processes at least one function or operation, may be implemented as hardware or software, or may be implemented as a combination of hardware and software.

Connections of lines or connection members between elements shown in the drawings are illustrative of functional connections and/or physical or circuitry connections, and may be replaced in an actual device, or may be represented as additional various functional connections, physical connections, or circuitry connections.

The use of all examples or example terms is merely for describing the technical concept in detail, and the scope thereof is not limited by these examples or example terms unless limited by claims.

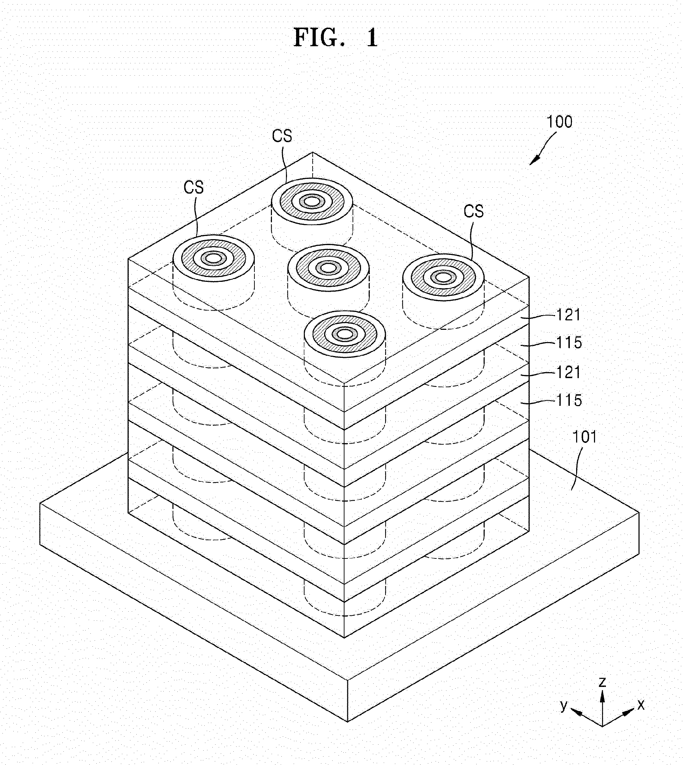

FIG. 1 is a perspective view illustrating a variable resistance memory device 100 according to an embodiment. The variable resistance memory device 100 shown in FIG. 1 may be, for example, a vertical NAND (VNAND) flash memory device.

Referring to FIG. 1, the variable resistance memory device 100 includes a plurality of cell strings CS disposed on a substrate 101. Each cell string CS may extend in a direction (z-axis direction in FIG. 1) perpendicular to the substrate 101. The plurality of cell strings CS may be arranged in various shapes on the substrate 101.

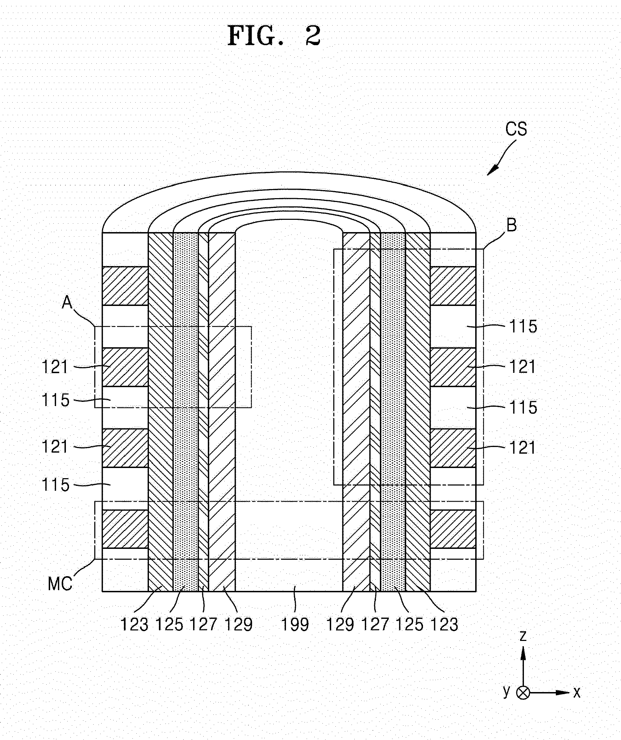

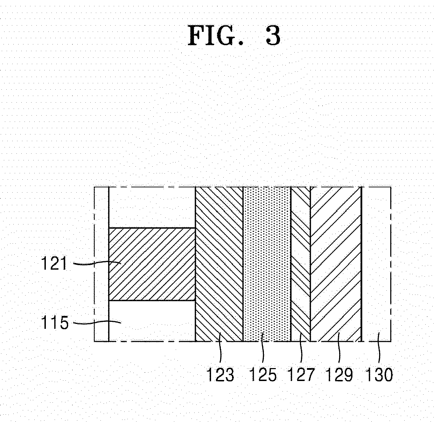

FIG. 2 is a cross-sectional view illustrating the cell string CS shown in FIG. 1 according to an embodiment. FIG. 3 is an enlarged view of portion A of a memory cell MC shown in FIG. 2 according to an embodiment.

Referring to FIGS. 2 and 3, the cell string CS includes a plurality of memory cells MC stacked in a direction (z-axis direction) perpendicular to the substrate 101. The substrate 101 may include various materials. For example, the substrate 110 may include, but is not limited to, a single crystal silicon substrate, a compound semiconductor substrate, or a silicon on insulator (SOI) substrate. In addition, the substrate 101 may further include, for example, an impurity region formed by doping, an electronic apparatus such as a transistor, or a peripheral circuit that select and control the memory cells MC that store data.

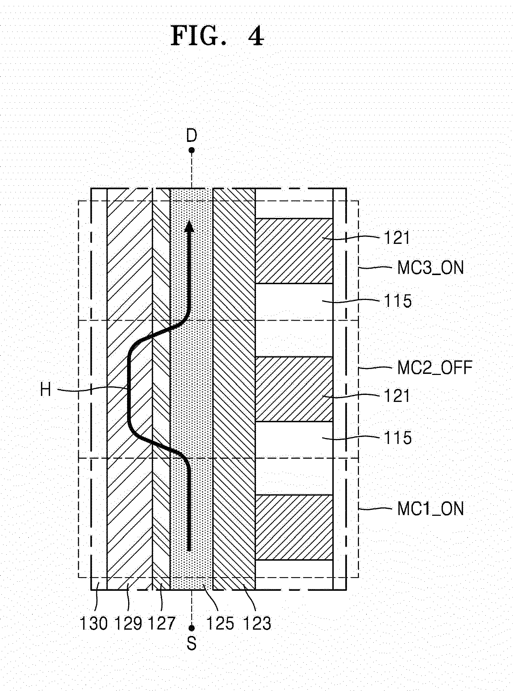

The cell string CS includes a plurality of gate electrodes 121 stacked and spaced apart from each other the direction (z-axis direction) perpendicular to the substrate 101. The cell string CS includes a gate insulating layer 123, a channel layer 125, an interface layer 127, and a resistance change layer 129 that are sequentially provided inside the gate electrodes 121 in a direction parallel to the substrate 101. The cell string CS may omit a charge trap layer and may instead include the resistance change layer 129 to decrease the spacing between gate electrodes 121 while preventing interference among them. Each of the gate insulating layer 123, the channel layer 125, the interface layer 127, and the resistance change layer 129 may be extend perpendicularly to the substrate 101 and may be shared by the plurality of memory cells MC. A source (S in FIG. 4) and a drain (D in FIG. 4) may be provided at lower and upper portions of the channel layer 125, respectively, and connected to a common source line and a bit line, respectively, as described below.

The gate electrode 121 may control the channel layer 125 corresponding thereto, and a word line may be electrically connected to the gate electrode 121. A voltage that turns on/off the channel layer 125 corresponding to the gate electrode 121 may be selectively applied to the gate electrode 121.

The gate electrode 121 may include, for example, a metal material with excellent electrical conductivity such as gold (Au), metal nitride, silicon doped with impurities, or a two-dimensional (2D) conductive material. However, this is merely an example, and the gate electrode 121 may include various other materials. Interlayer insulating layers 115 may be provided between the gate electrodes 121, and each serve as a spacer layer for insulation between the gate electrodes 121. The interlayer insulating layer 115 may include, for example, silicon oxide, silicon nitride, etc., but is not limited thereto.

Channel holes 199 are formed to penetrate the interlayer insulating layers 115 and the gate electrodes 121 in the direction (z-axis direction) perpendicular to the substrate 101. For example, the channel hole 199 may be formed to have, for example, a circular cross-section. The gate insulating layer 123, the channel layer 125, the interface layer 127, and the resistance change layer 129 are sequentially provided on an inner wall of the channel hole 199 in the direction parallel to the substrate 101. Each of the gate insulating layer 123, the channel layer 125, the interface layer 127, and the resistance change layer 129 may be formed to have a cylindrical shape extending in the direction (z-axis direction) perpendicular to the substrate 101. A filling insulating layer 130 (see FIG. 3) may be provided to fill the channel holes 199 inside the resistance change layer 129. The filling insulating layer 130 may include, for example, silicon oxide or air, but is not limited thereto.

The channel layer 125 may include a semiconductor material. The channel layer 125 may include, for example, Si, Ge, SiGe, or group III-V semiconductor. As a specific example, the channel layer 125 may include poly-Si, but is not limited thereto. In addition, the channel layer 125 may include, for example, an oxide semiconductor, a nitride semiconductor, a nitride semiconductor, a 2D semiconductor material, quantum dot, or an organic semiconductor. Here, the oxide semiconductor may include, for example, InGaZnO, etc., the 2D semiconductor material may include, for example, transition metal dichalcogenide (TMD) or graphene, and the quantum dot may include colloidal QD, a nanocrystal structure, etc. However, this is merely an example, and the embodiments are not limited thereto.

The channel layer 125 may further include a dopant. The dopant may include a p-type dopant or an n-type dopant. The p-type dopant may include, for example, a Group III element such as B, Al, Ga, In, etc., and the n-type dopant may include a Group V element such as P, As, Sb, etc.

The gate insulating layer 123 is provided between the gate electrode 121 and the channel layer 125. The gate insulating layer 123 may include various types of insulating materials. For example, silicon oxide, silicon nitride, or silicon oxynitride may be used in the gate insulating layer 123.

The resistance change layer 129 is provided inside the channel layer 125. The resistance change layer 129 may include a material having resistance characteristics that change according to an applied voltage. The resistance change layer 129 may include, for example, Al₂O₃, In₂O₃, MgO, MoO₃, Ta₂O₅, TiO₂, V₂O₅, or ZnO. However, this is merely an example.

The resistance characteristics of the resistance change layer 129 depend on the formation of a conductive filament due to the behavior of oxygen occurred within the resistance change layer 129 according to the applied voltage. Specifically, when a certain voltage is applied to the resistance change layer 129, an oxygen vacancy is formed within the resistance change layer 129, and oxygen vacancies thus formed are gathered to form the conductive filament. In addition, oxygen ions located in the oxygen vacancies move to the channel layer 125 by diffusion. The formation of the conductive filament reduces the resistance of the resistance change layer 129. That is, the resistance change layer 129 changes from a high resistive state (HRS) to a low resistive state (LRS).

The resistance change layer 129 may exhibit the HRS or the LRS according to whether the conductive filament is formed, and accordingly, may record information of '1' or '0'. An applied voltage that changes the resistance change layer 129 from the HRS to the LRS may be referred to as a set voltage V_{SET}, and an applied voltage that changes the resistance change layer 129 from the LRS to the HRS may be referred to as a reset voltage V_{RESET}.

The interface layer 127 is provided between the channel layer 125 and the resistance change layer 129. As will be described below, the interface layer 127 may serve to control the movement of oxygen ions during a RESET operation. The interface layer 127 may include, for example, Al₂O₃, In₂O₃, MgO, MoOs, Ta₂O₅, TiO₂, V₂O₅, or ZnO. However, this is merely an example. The interface layer 127 may have a thickness of approximately 0.5 nm to 3 nm, but is not limited thereto.

The interface layer 127 may include a material having an oxygen diffusion activation energy greater than an oxygen diffusion activation energy of the resistance change layer 129 in order to control the diffusion movement of oxygen ions. The oxygen diffusion activation energy is required for oxygen ions to diffuse and move. Specifically, the interface layer 127 may include the material having the oxygen diffusion activation energy that is approximately about 0.2 eV to about 0.8 eV greater than the oxygen diffusion activation energy of the resistance change layer 129. Table 1 below lists the oxygen diffusion activation energy of each of materials.

**[Table 1]**

| Furtherance | Oxygen diffusion activation energy (eV) |
|---|---|
| Al₂O₃ | 1.3 |
| In₂O₃ | 2.2 |
| MgO | 2.1 |
| MoO₃ | 1.6 |
| Ta₂O₅ | 1.2 |
| TiO₂ | 0.6 |
| V₂O₅ | 1.35 |
| ZnO | 1.49 |

Table 2 below shows an example where an oxygen diffusion activation energy difference value ΔEₐ between the interface layer 127 and the resistance change layer 129 is 0.2 eV to 0.8 eV.

**[Table 2]**

| Composition of interface layer | Composition of resistance change layer | ΔEₐ (eV) |
|---|---|---|
| Ta₂O₅ | TiO₂ | 0.6 |
| Al₂O₃ | TiO₂ | 0.7 |
| V₂O₅ | TiO₂ | 0.75 |
| MoO₃ | Ta₂O₅ | 0.4 |
| ZnO | Ta₂O₅ | 0.29 |
| MgO | Al₂O₃ | 0.8 |
| MoO₃ | Al₂O₃ | 0.3 |
| MgO | V₂O₅ | 0.75 |
| MoO₃ | V₂O₅ | 0.25 |
| In₂O₃ | ZnO | 0.71 |
| MgO | ZnO | 0.61 |
| In₂O₃ | MoO₃ | 0.6 |
| MgO | MoO₃ | 0.5 |

Referring to Table 2, the composition of the resistance change layer 129 and the composition of the interface layer 127 may be selected as follows. For example, when the resistance change layer 129 includes TiO₂, the interface layer 127 may include Ta₂O₅, Al₂O₃, or V₂O₅. For example, when the resistance change layer 129 includes Ta₂O₅, the interface layer 127 may include MoOs or ZnO. For example, when the resistance change layer 129 includes Al₂O₃, the interface layer 127 may include MgO or MoOs. For example, when the resistance change layer 129 includes V₂O₅, the interface layer 127 may include MgO or MoOs. For example, when the resistance change layer 129 includes ZnO, the interface layer 127 may include In₂O₃ or MgO. When the resistance change layer 129 includes MoOs, the interface layer 127 may include In₂O₃ or MgO.

The operation of the variable resistance memory device 100 described above is described below with reference to FIG. 4.

FIG. 4 is an enlarged view of portion B of FIG. 2 according to an embodiment. Referring to FIG. 4, when a memory cell MC2 to be written is selected, a gate voltage value of the corresponding memory cell MC2 is adjusted such that a channel is not formed in the selected memory cell MC2 (that is, the channel is turned off), and gate voltage values of unselected memory cells MC1 and MC3 are adjusted such that channels are turned on in the unselected memory cells MC1 and MC3.

In FIG. 4, a gate voltage is applied to the gate electrode 121 of each of the memory cells MC1, MC2, and MC3 such that the memory cell MC2 in the middle is turned off and the two memory cells MC1 and MC3 below and above the memory cell MC2 are turned on. When a voltage is applied between a source S and a drain D, a conduction path as shown by an arrow H is formed. Desired information of 1 or 0 may be written to the selected memory cell MC2 by setting an applied voltage between the source S and the drain D as the set voltage V_{SET} or the reset voltage V_{RESET}.

In a read operation, similarly, reading of the selected memory cell MC2 may be performed. That is, after the gate voltage applied to the gate electrode 121 of each of the memory cells MC1, MC2, and MC3 is adjusted such that the channel is turned off in the selected memory cell MC2 and the channels are turned on in the unselected memory cells MC1 and MC3, current flowing in the memory cell MC2 is measured by an applied voltage V_{read} between the source S and the drain D, and thus, a state (1 or 0) of the memory cell MC2 may be determined.

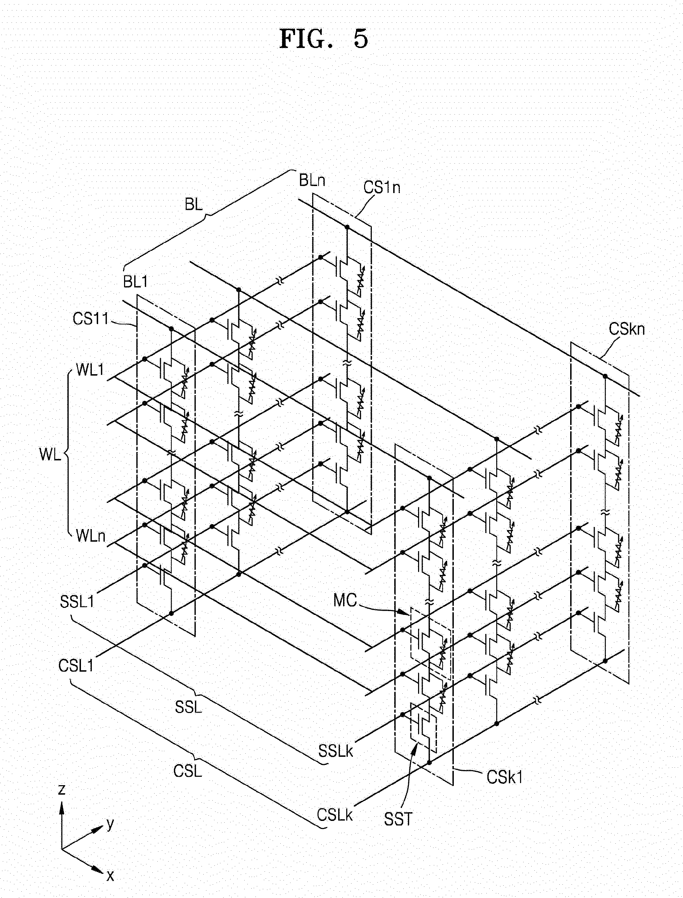

FIG. 5 is a circuit diagram of the variable resistance memory device 100 shown in FIG. 1 according to an embodiment.

Referring to FIG. 5, k*n cell strings CS may be provided and arranged in a matrix form, and identified as CSij (1≤i≤k, 1≤j≤n) according to positions of each row and column. Each cell string CSij is connected to a bit line BL, a string selection line SSL, a word line WL, and a common source line CSL.

Each cell string CSij includes the memory cells MC and a string selection transistor SST. The memory cells MC and the string selection transistor SST of each cell string CSij may be stacked in a height direction.

Rows of the plurality of cell strings CS are respectively connected to different string selection lines SSL1 to SSLk. For example, the string selection transistors SST of cell strings CS11 to CS1n are commonly connected to the string selection line SSL1. The string selection transistors SST of cell strings CSk1 to CSkn are commonly connected to the string selection line SSLk.

Columns of the plurality of cell strings CS are respectively connected to different bit lines BL1 to BLn. For example, the memory cells MC and the string selection transistors SST of the cell strings CS11 to CSk1 may be commonly connected to the bit line BL1, and the memory cells MC and the string selection transistors SST of the cell strings CS1n to CSkn may be commonly connected to the bit line BLn.

Rows of the plurality of cell strings CS may be respectively connected to different common source lines CSL1 to CSLk. For example, the string selection transistors SST of the cell strings CS11 to CS1n may be commonly connected to the common source line CSL1, and the string selection transistors SST of the cell strings CSk1 to CSkn may be commonly connected to the common source line CSLk.

The gate electrodes 121 of the memory cells MC located at the same height from the substrate 101 or the string selection transistors SST may be commonly connected to one word line WL, and the gate electrodes 121 of the memory cells MC located at different heights may be respectively connected to different word lines WL1 to WLm.

The circuit structure shown in FIG. 5 is an example. For example, the number of rows of the cell strings CS may be increased or decreased. As the number of rows of the cell strings CS is changed, the number of string selection lines connected to the rows of the cell strings CS and the number of cell strings CS connected to one bit line may also be changed. As the number of rows of the cell strings CS is changed, the number of common source lines connected to the rows of cell strings CS may also be changed.

The number of columns of cell strings CS may also be increased or decreased. As the number of columns of cell strings CS is changed, the number of bit lines connected to the columns of cell strings CS and the number of cell strings CS connected to one string selection line may also be changed.

The height of the cell string CS may also be increased or decreased. For example, the number of memory cells MC stacked in each cell string CS may be increased or decreased. As the number of memory cells MC stacked in each cell string CS is changed, the number of word lines WL may also be changed. For example, the string selection transistors provided to each of the cell strings CS may be increased. As the number of string selection transistors provided to each of the cell strings CS is changed, the number of string selection lines or common source lines may also be changed. As the number of string selection transistors is increased, the string selection transistors may be stacked in the same form as the memory cells MC.

As an example, writing and reading may be performed in units of rows of the cell strings CS. The cell strings CS may be selected in units of one row by the common source lines CSL, and the cell strings CS may be selected in units of one row by the string selection lines SSL. In addition, voltages may be applied to at least two common source lines CSL in one unit. Voltages may be applied to all of the common source lines CSL in one unit.

In selected rows of the cell strings CS, writing and reading may be performed in units of pages. A page may be one row of the memory cells MC connected to one word line WL. In the selected rows of the cell strings CS, the memory cells MC may be selected in units of pages by the word lines WL.

The memory cell MC has a circuit structure in which a transistor including the gate electrode 121, the gate insulating layer 123, and the channel layer 125 and a variable resistor formed by the resistance change layer 129 are connected in parallel. Such parallel connection structures are continuously arranged in a vertical direction (z-axis direction) to form the cell string CS. In addition, the common source line CSL and the bit line BL may be connected to both ends of the cell string CS. By applying voltages to the common source line CSL and the bit line BL, program, read, and erase processes may be performed on the plurality of memory cells MC.

For example, when the memory cell MC to be written is selected, a gate voltage value of the corresponding memory cell MC is adjusted such that a channel is not formed in the selected memory cell MC (that is, the channel is turned off), and gate voltage values of the unselected memory cells MC are adjusted such that channels are turned on in the unselected memory cells MC. Accordingly, the current path caused by the voltage applied to the common source line CSL and the bit line BL passes through a region of the resistance change layer 129 of the selected memory cell MC and, at this time, the resistance change layer 129 may be changed to the LRS or the HRS by setting an applied voltage as the set voltage V_{SET} or the reset voltage V_{RESET}, and desired information of 1 or 0 may be written to the selected memory cell MC.

In the read operation, similarly, reading of the selected memory cell MC may be performed. That is, after the gate voltage applied to the gate electrode 121 of each of the memory cells MC is adjusted such that the channel is turned off in the selected memory cell MC and the channels are turned on in the unselected memory cells MC, current flowing in the memory cell MC is measured by the applied voltage V_{read} between the common source line CSL and the bit line BL, and thus, a state (1 or 0) of the memory cell MC may be determined.

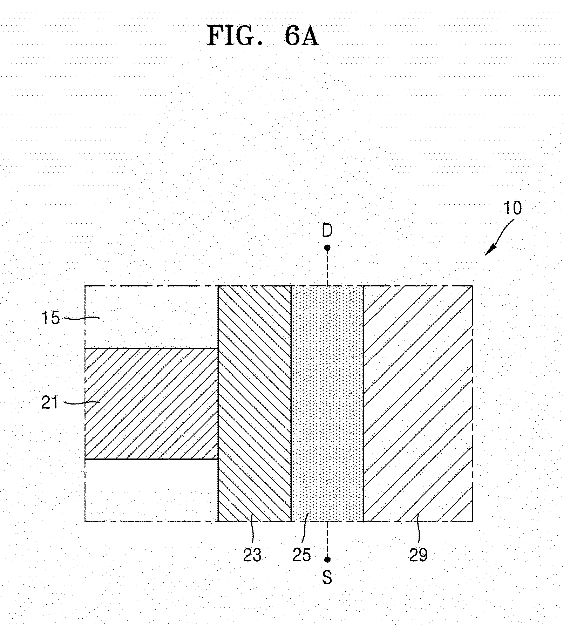

FIG. 6A is a diagram illustrating a variable resistance memory device 10 according to a comparative example. For convenience, FIG. 6A shows a cross-section of a part of a memory cell in the variable resistance memory device 10.

The variable resistance memory device 10 according to the comparative example shown in FIG. 6A does not include an interface layer between the channel layer 25 and the resistance change layer 29. Referring to FIG. 6A, the gate insulating layer 23, the channel layer 25, and the resistance change layer 29 are sequentially provided inside the gate electrode 21. Lower and upper portions of the channel layer 25 are connected to the source S and the drain D, respectively. The interlayer insulating layers 15 are provided on upper and lower portions of the gate electrode 21, respectively.

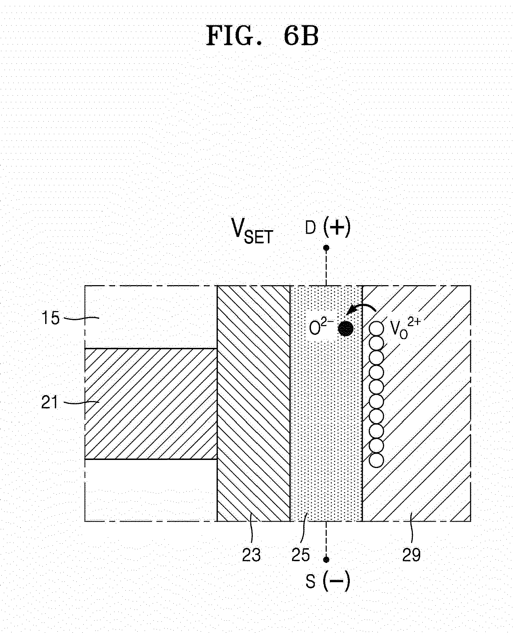

FIG. 6B is a diagram illustrating a state in which the set voltage V_{SET} is applied to the variable resistance memory device 10 shown in FIG. 6A.

Referring to FIG. 6B, when the set voltage V_{SET} is applied between the source S and the drain D, oxygen vacancies Vₒ²⁺ and interstitial oxygen ions O²⁻ are formed inside the resistance change layer 29, and at this time, the oxygen vacancies Vₒ²⁺ are gathered together to form a conductive filament. In addition, the interstitial oxygen ions O²⁻ move to the channel layer 25 by diffusion. The formation of the conductive filament reduces the resistance of the resistance change layer 29, and the resistance change layer 129 changes from the HRS to the LRS.

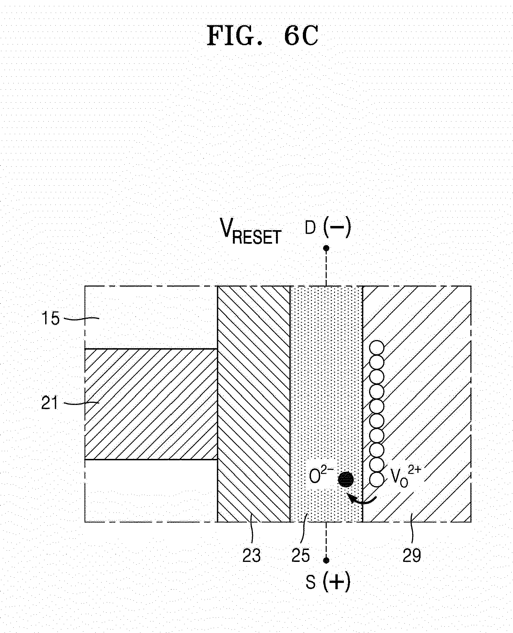

FIG. 6C is a diagram illustrating a state in which the reset voltage V_{RESET} is applied to the variable resistance memory device 10 shown in FIG. 6B.

Referring to FIG. 6C, even though the reset voltage V_{RESET} which is the opposite voltage to the set voltage V_{SET} is applied between the source S and the drain D, the oxygen ions O²⁻ within the resistance change layer 29 may diffuse and move to the channel layer 25 to which (+) voltage is applied. Accordingly, the oxygen vacancies Vₒ²⁺ are continuously supplied into the resistance change layer 29, which may cause a phenomenon in which a conductive filament formed by the oxygen vacancies Vₒ²⁺ is not broken. As described above, when the conductive filament is not broken, reset efficiency is reduced, and repetitive switching does not occur. Thus, endurance of the variable resistance memory device 10 may be reduced.

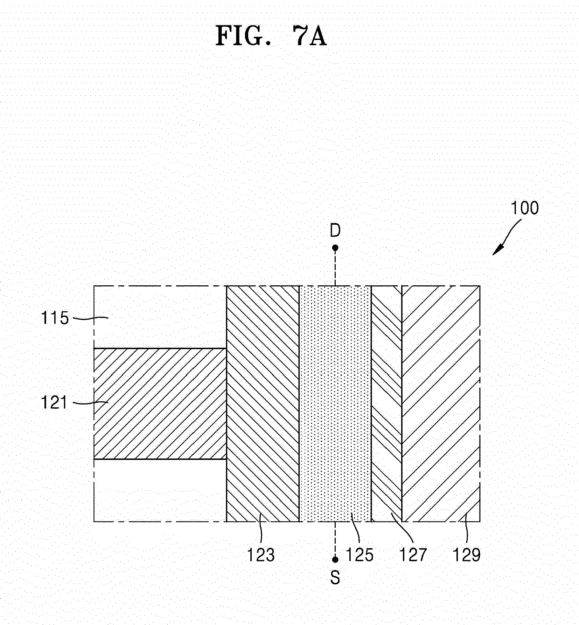

FIG. 7A is a diagram illustrating the variable resistance memory device 100 according to an embodiment. The variable resistance memory device 100 shown in FIG. 7A may include aspects similar to the variable resistance memory device 100 according to the embodiment shown in FIG. 3.

Referring to FIG. 7A, the gate insulating layer 123, the channel layer 125, the interface layer 127, and the resistance change layer 129 are sequentially provided inside the gate electrode 121. As described above, the interface layer 127 may include a material having an activation energy greater than an oxygen diffusion activation energy of the resistance change layer 129. Specifically, the interface layer 127 may include the material having the oxygen diffusion activation energy that is approximately about 0.2 eV to about 0.8 eV greater than the oxygen diffusion activation energy of the resistance change layer 129. Lower and upper portions of the channel layer 25 are connected to the source S and the drain D, respectively.

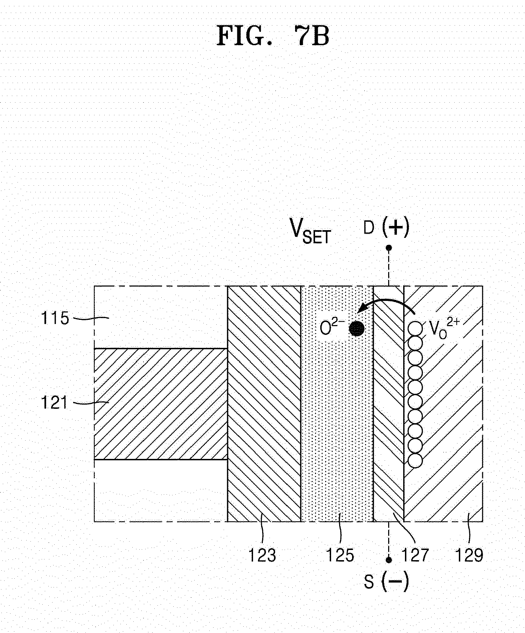

FIG. 7B is a diagram illustrating a state in which the set voltage V_{SET} is applied to the variable resistance memory device 100 shown in FIG. 7A according to an embodiment.

Referring to FIG. 7B, when the set voltage V_{SET} is applied between the source S and the drain D, the oxygen vacancies Vₒ²⁺ and the interstitial oxygen ions O²⁻ are formed inside the resistance change layer 129, and the oxygen vacancies Vₒ²⁺ are gathered together to form a conductive filament. In addition, the interstitial oxygen ions O²⁻ move to the channel layer 125 by diffusion. The formation of the conductive filament reduces the resistance of the resistance change layer 129, and the resistance change layer 129 changes from the HRS to the LRS.

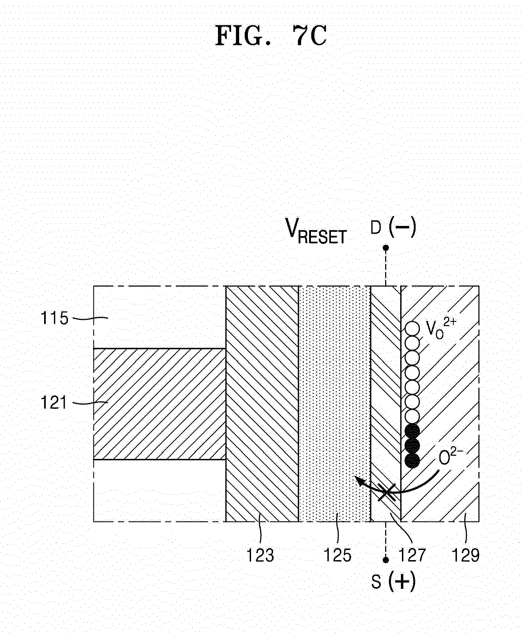

FIG. 7C is a diagram illustrating a state in which the reset voltage V_{RESET} is applied to the variable resistance memory device 100 shown in FIG. 7B according to an embodiment.

Referring to FIG. 7C, when the reset voltage V_{RESET} which is the opposite voltage to the set voltage V_{SET} is applied between the source S and the drain D, the oxygen ions O²⁻ within the resistance change layer 129 may not move to the channel layer 125 due to the interface layer 127 having the activation energy greater than the activation energy of the resistance change layer 129. Accordingly, the oxygen vacancies Vₒ²⁺ are not additionally generated within the resistance change layer 129, and thus, the conductive filament formed by the oxygen vacancies Vₒ²⁺ may be broken. Accordingly, the resistance of the resistance change layer 129 is increased, and the resistance change layer 129 changes from the LRS to the HRS. As described above, in the variable resistance memory device 100 according to an embodiment, the interface layer 127 having the activation energy greater than the activation energy greater of the resistance change layer 129 is provided between the channel layer 125 and the resistance change layer 129, and thus, reset efficiency may be increased, and accordingly, the endurance of the variable resistance memory device 100 may be improved.

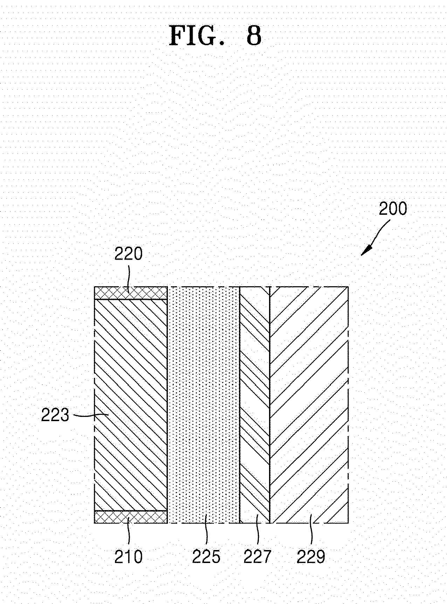

FIG. 8 is a diagram illustrating a model of a variable resistance memory device 200 manufactured to measure I-V characteristics through simulation experiments according to an embodiment.

Referring to FIG. 8, a lower electrode 210 and an upper electrode 220 are provided on one side of a channel layer 225, and an insulating layer 223 is provided between the lower electrode 210 and the upper electrode 220. An interface layer 227 and a resistance change layer 229 are sequentially provided on the other side of the channel layer 225.

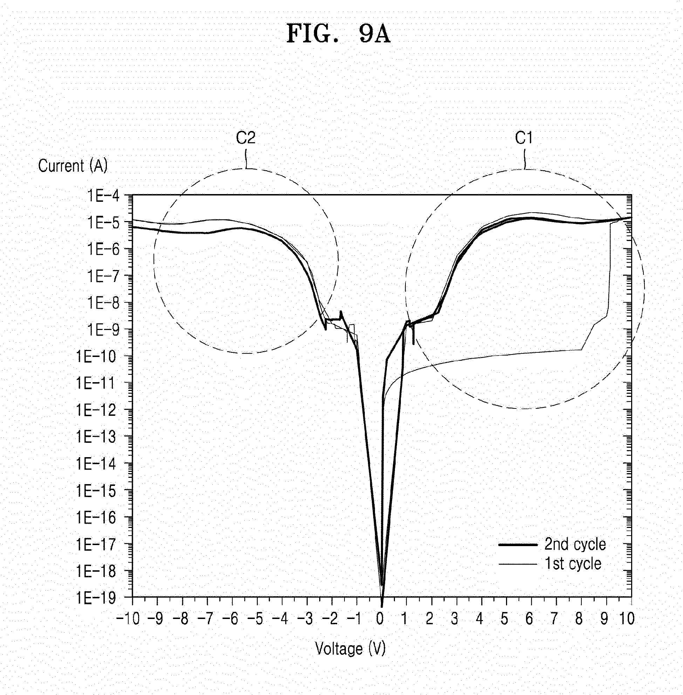

FIG. 9A is a graph illustrating I-V characteristics when the interface layer 227 has the same oxygen diffusion activation energy as the resistance change layer 229 in the variable resistance memory device 200 shown in FIG. 8 according to an embodiment. FIG. 9A shows results of calculating the I-V characteristics using technology computer-aided design (TCAD) according to a voltage applied between the lower electrode 210 and the upper electrode 220. A material having an oxygen diffusion activation energy of 0.4 eV is used as the resistance change layer 229 and the interface layer 227.

In FIG. 9A, "C1" and "C2" indicate cases where a set voltage and a reset voltage are applied between the lower electrode 210 and the upper electrode 220, respectively. The set voltage may be in a range from 1 V to 9 V, and the reset voltage may be in a range from -9 V to -3 V. Referring to FIG. 9A, when the interface layer 227 has the same oxygen diffusion activation energy as the resistance change layer 229, it may be seen that the reset operation is not performed because on/off does not appear even when the reset voltage is applied. When the reset voltage (e.g., -7 V) is applied, the current remains substantially consistent with that during the application of the set voltage (e.g., 9 V). As a result, transitioning from the set voltage to the reset voltage does not change the on-state to an off-state.

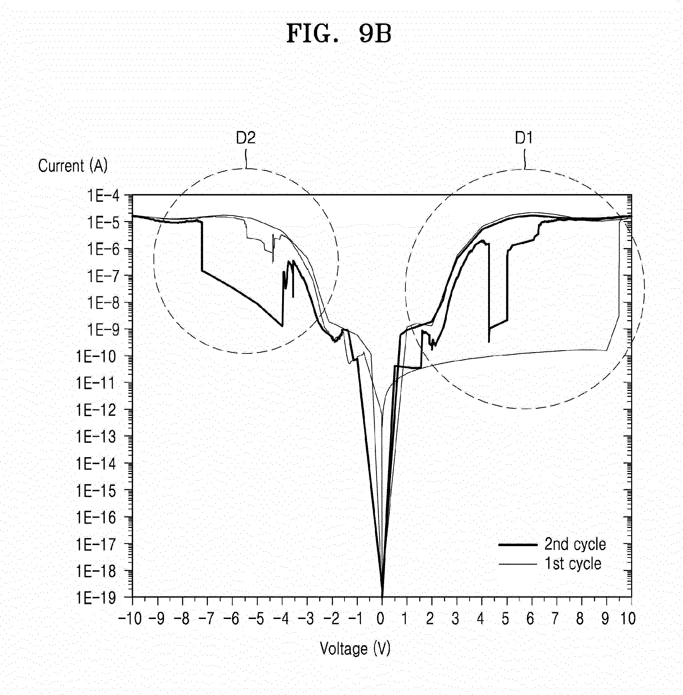

FIG. 9B is a graph illustrating I-V characteristics when the interface layer has a greater oxygen diffusion activation energy than the resistance change layer in the variable resistance memory device shown in FIG. 8 according to an embodiment. FIG. 9B shows the results of calculating I-V characteristics using TCAD according to the voltage applied between the lower electrode 210 and the upper electrode 220. The resistance change layer 229 used a material with an oxygen diffusion activation energy of 0.4 eV, and the interface layer 227 used a material with an oxygen diffusion activation energy of 1.0 eV.

In FIG. 9B, "D1" and "D2" indicate a case where a set voltage and a reset voltage are applied between the lower electrode 210 and the upper electrode 220, respectively. The set voltage may be in a range from 1 V to 9 V, and the reset voltage may be in a range from -9 V to -3 V. Referring to FIG. 9B, it may be seen that when the interface layer 227 has an oxygen diffusion activation energy greater than an oxygen diffusion activation energy of the resistance change layer 229, a set operation and a reset operation are performed smoothly. Specifically, when the applied voltage changes from the set voltage (e.g., 9 V) to the reset voltage (e.g., -7 V), the current drops as illustrated in region D2 and therefore the on-state is changed to the off-state.

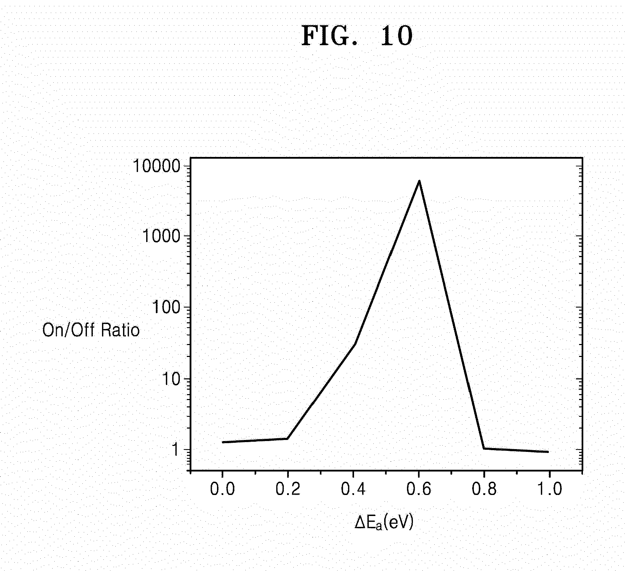

FIG. 10 is a graph illustrating an on/off current ratio according to an oxygen diffusion activation energy difference ΔEₐ between the interface layer 227 and the resistance change layer 229 in the variable resistance memory device 200 shown in FIG. 8 according to an embodiment. Referring to FIG. 10, it may be seen that the on/off current ratio increases when the interface layer 227 includes a material having the oxygen diffusion activation energy which is approximately 0.2 eV to 0.8 eV greater than the oxygen diffusion activation energy of the resistance change layer 229. When the oxygen diffusion activation energy difference ΔEₐ between the interface layer 227 and the resistance change layer 229 is less than 0.2 eV, the reset operation may not be performed, and when the oxygen diffusion activation energy difference ΔEₐ between the interface layer 227 and the resistance change layer 229 is greater than 0.8 eV, the set operation may not be performed.

In the above, the case where the variable resistance memory device 100 is a vertical NAND flash memory device in which the memory cells MC are arranged in a direction perpendicular to the substrate 101 along the cell string CS is described. However, the disclosure is not limited thereto, and as will be described below, a variable resistance memory device in which memory cells are arranged in a direction parallel to a substrate may also be implemented.

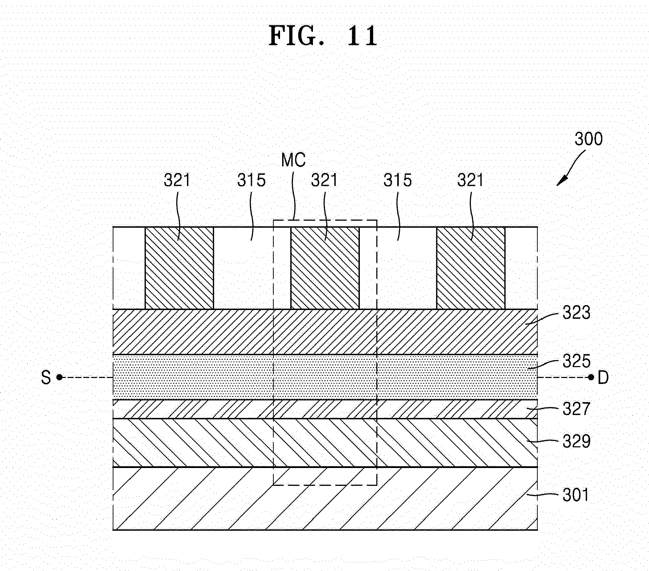

FIG. 11 is a diagram illustrating a variable resistance memory device 300 according to an embodiment. Hereinafter, the variable resistance memory device 300 may include aspects similar to those described above, and repeated descriptions may be omitted.

Referring to FIG. 11, the plurality of memory cells MC are arranged in a direction parallel to a substrate 301. A resistance change layer 329, an interface layer 327, a channel layer 325, and a gate insulating layer 323 are sequentially stacked on the substrate 301 in a direction perpendicular to the substrate 301. A plurality of gate electrodes 321 are spaced apart from each other in the direction parallel to the substrate 301 in the gate insulating layer 323, and interlayer insulating layers 315 are provided between the gate electrodes 321.

A voltage that turns on/off a channel layer 325 corresponding to the gate electrode 321 may be selectively applied to the gate electrode 321. The channel layer 325 may include a semiconductor material. The channel layer 125 may further include a dopant. Both ends of the channel layer 325 may be connected to the source S and the drain D, respectively.

The resistance change layer 329 may include a material having resistance characteristics that change based on an applied voltage. The resistance change layer 329 may include, for example, Al₂O₃, In₂O₃, MgO, MoOs, Ta₂O₅, TiO₂, V₂O₅, or ZnO. However, this is merely an example. The resistance characteristics of the resistance change layer 329 depend on the formation of a conductive filament due to the behavior of oxygen occurred within the resistance change layer 329 according to the applied voltage.

The interface layer 327 is provided between the channel layer 325 and the resistance change layer 329. The interface layer 327 may include, for example, Al₂O₃, In₂O₃, MgO, MoOs, Ta₂O₅, TiO₂, V₂O₅, or ZnO, but this is merely an example. The interface layer 327 may have a thickness of approximately about 0.5 nm to about 3 nm, but is not limited thereto.

The interface layer 327 may include a material having an oxygen diffusion activation energy greater than an oxygen diffusion activation energy of the resistance change layer 329 in order to control the diffusion movement of oxygen ions. Specifically, the interface layer 327 may include the material having the oxygen diffusion activation energy that is approximately about 0.2 eV to about 0.8 eV greater than the oxygen diffusion activation energy of the resistance change layer 329.

As in the above-described embodiment, in the variable resistance memory device 300 according to embodiments, the interface layer 327 having the oxygen diffusion activation energy greater than the activation energy greater of the resistance change layer 329 is provided between the channel layer 325 and the resistance change layer 329, and thus, the diffusion movement of oxygen ions generated in the resistance change layer 329 may be controlled. Accordingly, reset efficiency of the variable resistance memory device 300 may be increased, and thus, the endurance thereof may be improved.

The variable resistance memory devices 100 and 300 according to the above-described embodiments may be employed as memory systems in various electronic apparatus. The variable resistance memory devices 100 and 300 may each be implemented as a memory block in chip form and used as a neuromorphic computing platform, or may be used to configure a neural network.

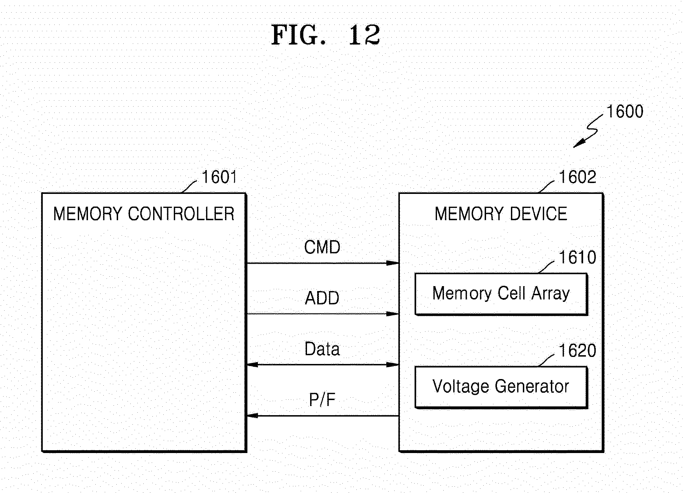

FIG. 12 is a block diagram illustrating a memory system 1600 according to an embodiment.

Referring to FIG. 12, the memory system 1600 may include a memory controller 1601 and a memory device 1602. The memory controller 1601 performs control operations on the memory device 1602. For example, the memory controller 1601 provides, to the memory device 1602, an address ADD and a command CMD to perform program (or write), read and/or erase operations on the memory device 1602. In addition, data for programming operations and read data may be transmitted between the memory controller 1601 and the memory device 1602.

The memory device 1602 may include a memory cell array 1610 and a voltage generator 1620. The memory cell array 1610 may include a plurality of memory cells arranged in a region where a plurality of word lines and a plurality of bit lines intersect each other. The memory cell array 1610 may include the variable resistance memory devices 100 and 300 according to the above-described embodiments.

The memory controller 1601 includes a processing circuitry such as hardware including a logic circuit, a hardware/software combination such as processor execution software, or a combination thereof. For example, the processing circuitry includes, more specifically, a central processing unit (CPU), an arithmetic logic unit (ALU), a digital signal processor, a microcomputer, a field programmable gate array (FPGA), a system-on-chip (SoC), a programmable logic unit, a microprocessor, an application-specific integrated circuit (ASIC), etc., but is not limited thereto. The memory controller 1601 may operate in response to a request from a host and may be converted into a special purpose controller by accessing the memory device 1602 and controlling the control operations (e.g., write/read operations) discussed above. The memory controller 1601 may generate the address ADD and the command CMD to perform the program/read/erase operations on the memory cell array 1610. In addition, in response to instructions from the memory controller 1601, the voltage generator 1620 (e.g., a power circuitry) may generate a voltage control signal for controlling a voltage level of a word line for programming or reading data on the memory cell array 1610.

In addition, the memory controller 1601 may perform a determination operation on the data read from the memory device 1602. For example, an on-cell number and/or off-cell number may be determined from data read from a memory cell. The memory device 1602 may provide a pass/fail signal P/F to the memory controller 1601 according to results of reading the read data. The memory controller 1601 may control the write and read operations of the memory cell array 1610 by referring to the pass/fail signal P/F.

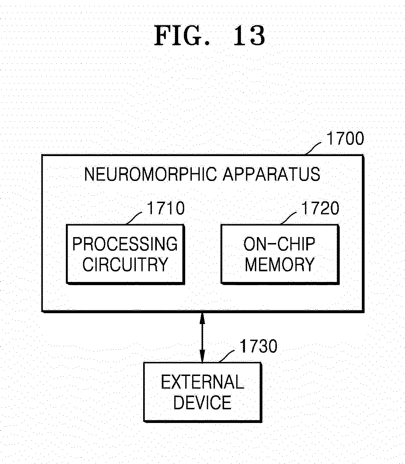

FIG. 13 is a block diagram illustrating a neuromorphic apparatus 1700 and an external device 1730 connected thereto according to an embodiment.

Referring to FIG. 13, the neuromorphic apparatus 1700 may include processing circuitry 1710 and/or an on-chip memory 1720. The neuromorphic apparatus 1700 may include the variable resistance memory devices 100 and 300 according to the above-described embodiment.

In some embodiments, the processing circuitry 1710 may be configured to control functions for driving the neuromorphic apparatus 1700. For example, the processing circuitry 1710 may be configured to control the neuromorphic apparatus 1700 by executing programs stored in the on-chip memory 1720 of the neuromorphic apparatus 1700. In some embodiments, the processing circuitry 1710 may include hardware such as a logic circuit, a hardware/software combination such as a processor executing software, or a combination thereof. For example, the processor may include, but is not limited to, a CPU, a graphics processing unit (GPU), an application processor (AP) included in the neuromorphic apparatus 1700, an ALU, a digital signal processor, a microcomputer, a FPGA, a SoC, a programmable logic unit, a microprocessor, an ASIC, etc. In some embodiments, the processing circuitry 1710 may be configured to read/write a variety of data from/in the external device 1730 and/or execute the neuromorphic apparatus 1700 by using the read/written data. In some embodiments, the external device 1730 may include an external memory and/or sensor array including an image sensor (e.g., a complementary metal-oxide-semiconductor (CMOS) image sensor circuit).

In some embodiments, the neuromorphic apparatus 1700 in FIG. 13 may be applied to a machine learning system. The machine learning system may use a variety of artificial neural network organizational and processing models, such as convolutional neural networks (CNN), de-convolutional neural networks, recurrent neural networks (RNN) optionally including a long short-term memory (LSTM) unit and/or a gated recurrent unit (GRU), stacked neural network (SNN), state-space dynamic neural network (SSDNN), deep belief network (DBN), generative adversarial network (GAN), and/or restricted Boltzmann machine (RBM).

Alternatively or additionally, such machine learning systems may, for example, include other forms of machine learning models, such as linear and/or logistic regression, statistical clustering, Bayesian classification, decision trees, dimensionality reduction such as principal component analysis, and expert systems; and/or combinations thereof, including ensembles such as random forests. Such machine learning models may be used to provide various services and/or applications. For example, an image classify service, a user authentication service based on bio-information or biometric data, an advanced driver assistance system (ADAS) service, a voice assistant service, an automatic speech recognition (ASR) service, etc. may be executed by electronic apparatuses.

The variable resistance memory devices 100, 200 and 300 described above have been described with reference to the embodiments shown in the drawings, but this is merely an example, and it will be understood by those of ordinary skill in the art that various modifications and other equivalent embodiments are possible therefrom.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A variable resistance memory device, comprising a cell string extending vertically on a substrate, wherein the cell string comprises:
a channel layer;
a resistance change layer provided on the channel layer, the resistance change layer having resistance characteristics that change based on an applied voltage and having a first oxygen diffusion activation energy; and
an interface layer provided between the channel layer and the resistance change layer, the interface layer having a second oxygen diffusion activation energy that is greater than the first oxygen diffusion activation energy of the resistance change layer.

2. The variable resistance memory device of claim 1, wherein the resistance change layer comprises Al₂O₃, In₂O₃, MgO, MoOs, Ta₂O₅, TiO₂, V₂O₅, or ZnO, and
wherein the interface layer comprises Al₂O₃, In₂O₃, MgO, MoOs, Ta₂O₅, TiO₂, V₂O₅, or ZnO.

3. The variable resistance memory device of claim 1 or 2, wherein the second oxygen diffusion activation energy of the interface layer is 0.2 eV to 0.8 eV greater than the first oxygen diffusion activation energy of the resistance change layer.

4. The variable resistance memory device of claim 3, wherein the resistance change layer comprises TiO₂, and
wherein the interface layer comprises Ta₂O₅, Al₂O₃, or V₂O₅.

5. The variable resistance memory device of claim 3, wherein the resistance change layer comprises Ta₂O₅, and
wherein the interface layer comprises MoOs or ZnO.

6. The variable resistance memory device of claim 3, wherein the resistance change layer comprises Al₂Os, and
wherein the interface layer comprises MgO or MoOs.

7. The variable resistance memory device of claim 3, wherein the resistance change layer comprises V₂O₅, and
wherein the interface layer comprises MgO or MoOs.

8. The variable resistance memory device of claim 3, wherein the resistance change layer comprises ZnO, and
wherein the interface layer comprises In₂O₃ or MgO.

9. The variable resistance memory device of claim 3, wherein the resistance change layer comprises MoOs, and
wherein the interface layer comprises In₂O₃ or MgO.

10. The variable resistance memory device of any preceding claim, wherein a thickness of the interface layer is 0.5 nm to 3 nm.

11. An electronic apparatus, comprising:
a plurality of variable resistance memory devices according to any preceding claim
wherein each of the plurality of cell strings comprises:
a plurality of gate electrodes provided outside the channel layer.
